# EUROPEAN PATENT APPLICATION

(11) **EP 4 531 079 A1**
(43) Date of publication of application: **02.04.2025**
(21) Application number: 23200512.4
(22) Date of filing: 28.09.2023
(51) Int. Cl.: H01L 21/56, H01L 23/31, H01L 23/495

(54) **SEMICONDUCTOR PACKAGE, METHOD OF MANUFACTURING A BATCH OF SEMICONDUCTOR PACKAGES AND ARRAY OF SEMICONDUCTOR PACKAGES**

(71) Applicant: Nexperia B.V., 6534 AB Nijmegen (NL)
(72) Inventor: Cheung, Yuet Keung, Hong Kong (HK); Ng, Siu Lung, Hong Kong (HK); Yeung, Shun Tik, Hong Kong (HK)
(74) Representative: Pjanovic, Ilija

(57) **Abstract**

There is disclosed a semiconductor package (2) for a PCB. The semiconductor package comprises a die paddle (12), a die (22), a plurality of leads (32, 34, 36) and an encapsulant (78). The die is coupled to the die paddle. The plurality of leads are electrically connected to the die. Each of the plurality of leads extend from the die at a first end, and define a pad (48, 74, 76) for attachment to the PCB (not shown) at a second end. The encapsulant at least partly surrounds the die and the plurality of leads. The encapsulant defines a thickness. The one or more of the plurality of leads (32, 34, 36) comprises an exposed portion (not yet there in the half-product of figure 2), the exposed portion being disposed partway along an extent of the lead between the first and second ends. The exposed portion is located partway along the thickness of the encapsulant (78).

## Description

The present invention relates to a semiconductor package, a method of manufacturing a batch of semiconductor packages, and an array of semiconductor packages.

Semiconductor packages, such as transistors, are manufactured as layered assemblies including components such as die paddles (e.g. thermal pads), dies (e.g. chips), leads (e.g. tracks) and an encapsulant (e.g. casing).

The leads of the semiconductor package, with multiple leads typically being electrically connected to the die, define pads (e.g. contacts) by which the semiconductor package is electrically connectable to a printed circuit board (PCB). In typical applications it is only by virtue of the pads that the entire semiconductor package is coupled to the PCB. This is usually by way of a soldered connection. In many applications, such as in the automotive sector, it is desirable to inspect the soldered joint, as part of a quality control process, to confirm that the semiconductor package is robustly connected to the PCB. An issue encountered with current processes is that a thickness of the solder between the pad and the leads is typically very thin (e.g. of the order of around 10 microns). Inspecting the solder at this scale presents a real challenge.

There exists a need to overcome the disadvantages associated with existing semiconductor packages, and associated methods of manufacture, whether mentioned in this document or otherwise.

According to a first aspect of the invention there is provided a semiconductor package for a PCB, comprising:
a die paddle;
a die coupled to the die paddle;
a plurality of leads electrically connected to the die, each of the plurality of leads extending from the die at a first end, and defining a pad for attachment to the PCB at a second end; and
an encapsulant which at least partly surrounds the die and the plurality of leads, the encapsulant defining a thickness; wherein
one or more of the plurality of leads comprises an exposed portion, the exposed portion disposed partway along an extent of the lead between the first and second ends, the exposed portion being located partway along the thickness of the encapsulant.

The semiconductor package may otherwise be described as a semiconductor assembly.

The die paddle may otherwise be described as a plate of conductive material. The die paddle may be manufactured from a copper alloy or entirely from copper. The die paddle may be described as a thermal pad.

The die may be a single component or may comprise multiple constituent components. The die is preferably coupled to the die paddle using solder. The die being coupled to the die paddle may otherwise be described as the die being attached to the die paddle. The die may be a silicon chip.

Each of the plurality of leads extending from the die at a first end may be described as the plurality of leads being coupled to the die at the first end. The pads of the plurality of leads may be described as a foot. A flank of the pads preferably comprises a plated metal material (e.g. layer).

The encapsulant may otherwise be described as a casing or shield. The encapsulant maybe described as encapsulating the die. The encapsulant advantageously reduces the risk of contaminants, such as moisture, penetrating into the semiconductor package. The encapsulant preferably extends between first and second major faces of the die paddle. The encapsulant may be plastic. The encapsulant may otherwise be described as being manufactured from a polymer. The encapsulant is preferably manufactured using an injection moulding process where an at least partially molten material is moulded into the desired encapsulant shape. The encapsulant may be a thermoplastic (e.g. a thermosetting polymer).

The exposed portion of the pluralities of leads may be described as a portion of the leads which projects from, or is not covered by, the encapsulant. The exposed portion may thus be visible. The exposed portion being disposed partway along an extent of the lead may otherwise be described as the exposed portion being located partway along a length of the lead. The lead may change direction one or more times along its extent. The exposed portion being located partway along the thickness of the encapsulant encompasses the exposed portion being surrounded by an encapsulant on all sides. Described another way, the exposed portion is not located at a lower or upper face of the semiconductor package, but somewhere inbetween.

Advantageously, the presence of the exposed portion means that when the semiconductor package is manufactured as part of an array, a semiconductor package can be electrically coupled to an adjacent semiconductor package to aid in the electroplating process, even after a first set of interconnecting tracks, which otherwise couples pairs of leads and pads together, is removed.

Each of the plurality of leads may comprise an exposed portion disposed partway along an extent of the lead between the first and second ends.

Each of the plurality of leads comprising an exposed portion advantageously improves the electrical conductivity between the semiconductor packages.

For one or more of the plurality of leads, the first end and the exposed portion may be defined by a layer.

The first end of the exposed portion being defined by a layer may otherwise be described as the first end and the exposed portion being provided at the same plane through the semiconductor package. That plane may be substantially parallel to the die paddle and/or the die.

Advantageously, providing the plurality of leads by way of a layer improves the efficiency of the manufacture process of the plurality of leads.

The encapsulant may comprise a stepped recess between the exposed portion and the pad of one or more of the plurality of leads.

Stepped recess may otherwise be described as a two part recess. Stepped recess may be said to comprise a cavity having a first width, and then an adjacent portion having a different width.

Advantageously, providing a stepped recess between the exposed portion and the pad of the one or more of the plurality of leads means that a first cavity can be formed to expose a flank of pads of the leads, for electroplating, whilst semiconductor packages still remain conjoined to one another by virtue of the fused encapsulant. When the array is cut, so as to singulate the semiconductor packages, the stepped recess advantageously reduces the risk of damage occurring to the plated flanks. Put another way, the width of the cavity is preferably wider than the adjacent portion. This reduces the risk of damage occurring when the array is singulated (i.e. at the array cut step).

One or more of the pads may comprise a metal plating, the metal plating extending at least partway along a flank of the one or more pads.

The metal plating may otherwise be described as a metal layer. The metal plating may comprise one or more of tin or silver. The metal plating extending at least partway along a flank of the one or more pads is intended to encompass the metal plating extending at least partway along a non-horizontal surface of the pad. For example, if the pad defines an underside and also has an associated height, the height may be described as defining a flank.

Preferably, each pad defined by a lead comprises a metal-plated flank.

Advantageously, at least part of a flank of the one or more pads comprising a metal plating means that the semiconductor package can be coupled to a PCB by both an underside and a flank of the pad. This means a greater thickness of solder can be used, which means a wider range of inspection processes can be used to confirm the soldered joint is robust and the semiconductor package is securely coupled to the PCB.

A first plurality of leads may extend from a first side of the die, and a second plurality of leads may extend from a second, opposing side of the die.

In some embodiments a first plurality of leads may extend from the first side of a die and then only a second plurality of leads may extend from a second, opposing side. Put another way, the third and four sides of the die may be absent of any leads. This may be described as a two-sided configuration.

A third plurality of leads may extend from a third side of the die, and a fourth plurality of leads may extend from a fourth side of the die, the fourth side of the die opposing the third side of the die.

The first, second, third and fourth sides of the die may define all sides of a four-sided die. Put another way, a respective plurality of leads may extend from each side of the die. This may be referred to as a four-sided configuration.

According to a second aspect of the invention there is provided a method of manufacturing a batch of semiconductor packages, comprising:
coupling a plurality of dies and a plurality of die paddles to define an array, wherein each die paddle defines a respective semiconductor package, and coupling an interconnected lead array and the plurality of dies, the interconnected lead array comprising a plurality of leads, connected to the plurality of dies, and a plurality of sets of interconnecting tracks which extend between coupled pairs of the plurality of leads: a first set of interconnecting tracks extending between pads of at least some of the coupled pairs, and a second set of interconnecting tracks extending between at least some of the coupled pairs from a position partway along an extent of the leads of the at least some of the coupled pairs;
providing at least part of a fused encapsulant over the plurality of semiconductor packages, the at least part of the fused encapsulant at least partly surrounding the array;
removing the first set of interconnecting tracks to define the pads, and expose a flank of the pads, of the plurality of leads;
plating at least part of an underside of the pads, and at least part of the flank of the pads, using an electrolytic plating process; and
cutting the fused encapsulant at a plurality of positions to singulate the semiconductor packages from the array, wherein cutting the fused encapsulant comprises removing the second set of interconnecting tracks to define exposed portions of the plurality of leads.

A batch of semiconductor packages may be referred to as a plurality of semiconductor packages.

The plurality of die paddles may be provided on a lead frame. The lead frame and/or die paddle(s) may otherwise be described as a plate of conductive material. The die paddle may be manufactured from a copper alloy or entirely from copper. The plurality of die paddles may be formed by plating a substrate. Alternatively. The plurality of die paddles may be formed be plating an underside of the die (i.e. the die paddles may be formed in-situ).

The plurality of leads may be described as being connected to each of the plurality of dies.

Each die paddle defining a respective semiconductor package may otherwise be described as each individual die paddle going on to form a separate semiconductor package.

The die may be a single component or may comprise multiple constituent components. The die is preferably coupled to the die paddle using a die attach, such as solder or epoxy. The plurality of dies may be coupled to the plurality of die paddles. The die being coupled to the die paddle may otherwise be described as the die being attached to the die paddle. The die may be a silicon chip. The plurality of dies may be coupled to a respective plurality of die paddles (e.g. one die per die paddle). Alternatively, the die paddles may be coupled to the die (e.g. the dies may already be positioned in-situ). The die paddles may be plated onto an underside of the dies.

The interconnected lead array may be provided by way of a plating process. The interconnected lead array may be coupled to the plurality of dies. The interconnected lead array may be formed by a plating process in which the leads are at least partially built onto the dies (e.g. where the dies are already in-situ). Alternatively, the interconnected lead array may be formed before the dies are located in-situ, and the dies may be subsequently coupled to the interconnected lead array.

The first sets of interconnecting tracks may extend between pads of all of the coupled pairs. The second set of interconnecting tracks may extend between all of the coupled pairs at a position partway along an extent of the leads of all of the coupled pairs. Coupled pairs is intended to refer to two adjacent semiconductor packages which are directly coupled to one another. The first and second sets of interconnecting tracks may each be described as comprising a plurality of constituent tracks. Each of the first and second sets of interconnecting tracks may be disposed at different positions through a thickness of encapsulant. For example, in preferred embodiments the second set of interconnecting tracks is disposed above the first set of interconnecting tracks. A portion of encapsulant is preferably disposed vertically between the first and second sets of interconnecting tracks.

Fused encapsulant is intended to refer to a conjoined encapsulant moulded in a single mould. For example, the fused encapsulant may be moulded over multiple respective semiconductor packages. The encapsulant may be plastic. The encapsulant may otherwise be described as being manufactured from a polymer. The encapsulant is preferably manufactured using an injection moulding process where an at least partially molten material is moulded into the desired encapsulant shape. The plastic may be a thermoplastic (e.g. a thermosetting polymer). The at least part of the fused encapsulant may comprise an entire fused encapsulant (e.g. a fused encapsulant extending to both major faces of the dies). The at least part of the fused encapsulant may comprise only a second portion of the fused encapsulant (e.g. extending from the leads towards, and past, the dies, and preferably up to the die paddles). Where the at least part of the fused encapsulant comprises only the second portion, the first portion of the fused encapsulant is formed in an earlier step of the method (and preferably a first step). Preferably, where the first portion of fused encapsulant is formed, the interconnected lead array is then formed, by plating, onto the first portion of the fused encapsulant. Dies may then be placed accordingly, and die paddles then coupled, or plated onto, the dies. The second portion of the fused encapsulant is then preferably moulded, before the first set of interconnecting tracks is removed.

Singulating the semiconductor package from array may otherwise be described as separating, or detaching, the semiconductor package from the array. Alternatively, it may be described as severing the semiconductor package from the array.

Advantageously, using the aforementioned method to manufacture a batch of semiconductor packages means that at least part of a flank of pads of semiconductor packages can be electroplated whilst the semiconductor packages remain electrically connected to one another as part of the array. In a subsequent cutting step the semiconductor packages are singulated such that the separate semiconductor packages are then provided but with the flanks at least partly plated.

Advantageously, a batch of semiconductor assemblies manufactured in accordance with the invention have a lower associated manufacture cost.

Cutting the fused encapsulant may comprise defining a stepped recess between the exposed portion and the pad of one or more of the plurality of leads of the semiconductor package.

The encapsulant may be moulded or provided by film lamination.

The interconnected lead array may be provided by plating or sputtering.

Removing the first set of interconnecting tracks to define pads, and expose a flank of the pads, of the plurality of leads, may occur by a cutting operation.

The cutting operation may be by way of a variety of different cutting processes including, but not limited to, a reciprocating or rotating blade (i.e. sawing), a laser, a waterjet or other similar process.

Plating at least part of an underside of the pads, and at least part of the flank of the pads, using an electrolytic plating process may comprise providing each of the plurality of leads at substantially the same potential by connecting the interconnected lead array to a supply circuit.

Plating at least part of an underside of the pads, and at least part of the flank of the pads, using an electrolytic plating process may comprise providing the at least part of the flank of the pads with at least 7 microns of plated material.

A height of the flank of the pads is preferably at least 100 microns.

According to a third aspect of the invention there is provided an array of semiconductor packages, comprising:
a lead frame comprising an array of die paddles, wherein each die paddle defines a respective semiconductor package;
a plurality of dies coupled to a respective plurality of die paddles;
an interconnected lead array extending between, and electrically coupling, the plurality of dies, the interconnected lead array comprising first and second sets of interconnecting tracks: a first set of interconnecting tracks extending between at least some of the pads of the coupled pairs of the plurality of dies, and a second set of interconnecting tracks extending between at least some of the coupled pairs from a position partway along an extent of the leads of the at least some of the coupled pairs; and
a fused encapsulant provided over the plurality of semiconductor packages, the fused encapsulant at least partly surrounding the array.

The optional and/or preferred features of each aspect of the invention as set out herein are also applicable to any other aspect of the invention where appropriate.

Embodiments of the present invention will now be described, by way of example only, with reference to the accompanying drawings in which:
Figure 1 is a schematic cross-section side view of an array of semiconductor packages in accordance with an embodiment of the invention, shown at an intermediate step of a process of manufacture;
Figure 2 is a magnified view of a region of interest of Figure 1, generally showing one semiconductor package of the array;
Figure 3 is a cross-section plan view of the array shown in Figure 1 for an array comprising semiconductor packages having a four-sided configuration;
Figure 4 is an underside view of the array shown in Figures 1 and 3;
Figure 5 is a cross-section plan view of the array shown in Figure 1, generally corresponding to the view of Figure 3 but for an array comprising semiconductor packages having a two-sided configuration;
Figure 6 is an underside view of the array shown in Figures 1 and 5, generally corresponding to the view shown in Figure 4 but for an array comprising semiconductor packages having a two-sided configuration;
Figure 7 is a cross-section side view of the array of semiconductor packages shown in the preceding Figures at a subsequent manufacture step;
Figure 8 is a magnified view of a region of interest of the array shown in Figure 7, generally corresponding to one semiconductor package;
Figure 9 is a view of the underside of the array shown in Figure 7 for an array comprising semiconductor packages having a four-sided configuration;
Figure 10 is an underside view of the array shown in Figure 7 for an array comprising semiconductor packages having a two-sided configuration;
Figure 11 is a cross-section side view of the array of semiconductor packages shown in the preceding Figures, at a subsequent manufacture step to that shown in Figures 7 to 10;
Figure 12 is a magnified view of a region of interest of Figure 11, generally corresponding to one semiconductor package;
Figure 13 is an underside view of the array of Figure 11 for an array comprising semiconductor packages having a four-sided configuration;
Figure 14 shows an underside of the array of Figure 11 for an array comprising semiconductor packages having a two-sided configuration;
Figure 15 is a cross-section side view of the array of semiconductor pacakges shown in the preceding Figures, at a subsequent manufacture step to that shown in Figures 11 to 14;
Figure 16 is a magnified view of a region of interest of Figure 15, generally corresponding to one semiconductor package;
Figure 17 is an underside view of the (singulated) array shown in Figure 15 for an array comprising semiconductor packages having a four-sided configuration; and
Figure 18 is an underside view of the (singulated) array of Figure 15 for an array comprising semiconductor packages having a two-sided configuration.
Turning to Figure 1, a cross-section side view of an array of semiconductor packages 2 is provided. From the view shown in Figure 1, four semiconductor packages 4, 6, 8, 10 are visible. The semiconductor packages 4, 6, 8, 10 may be referred to as first to fourth semiconductor packages respectively.

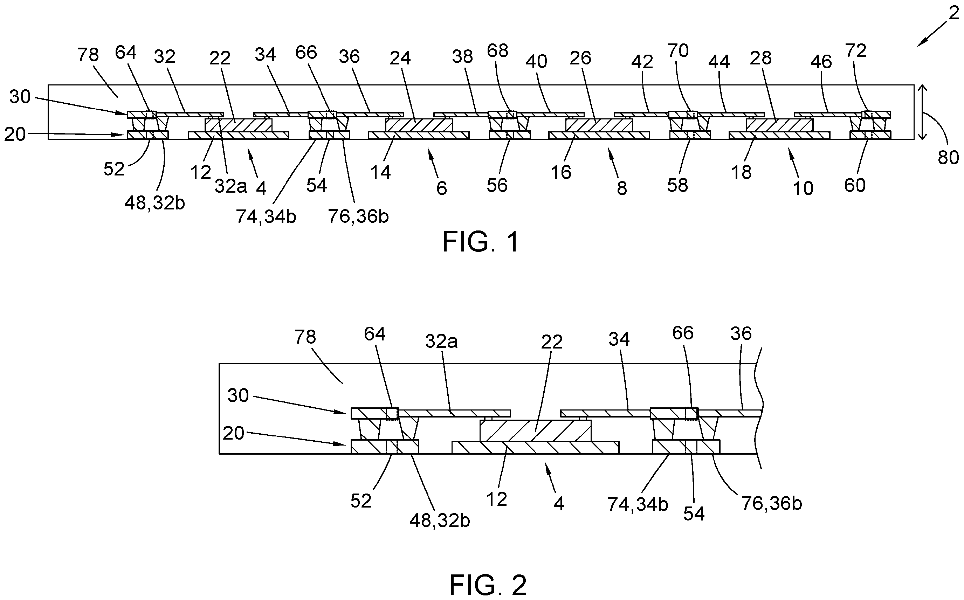

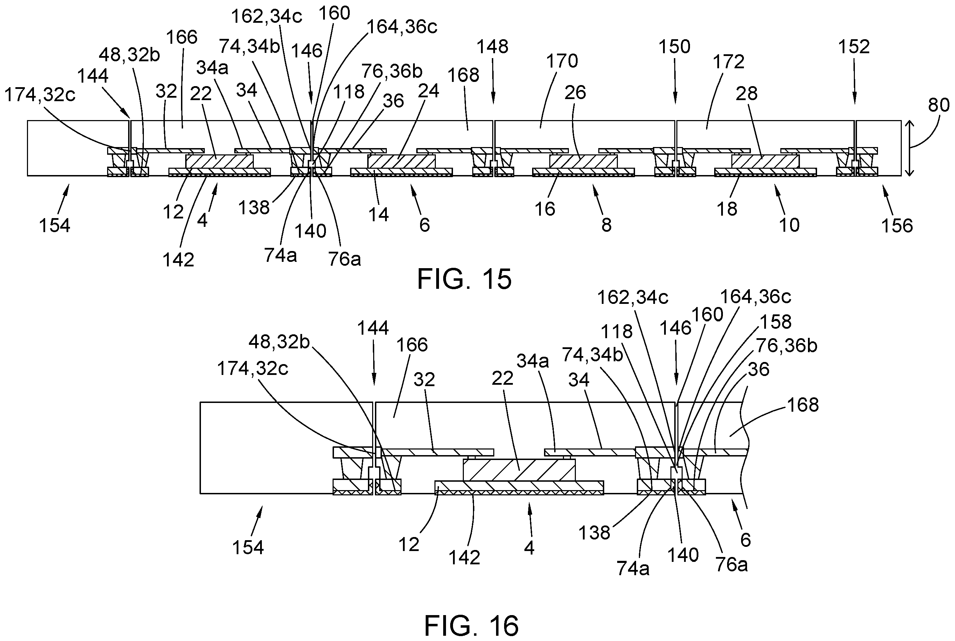

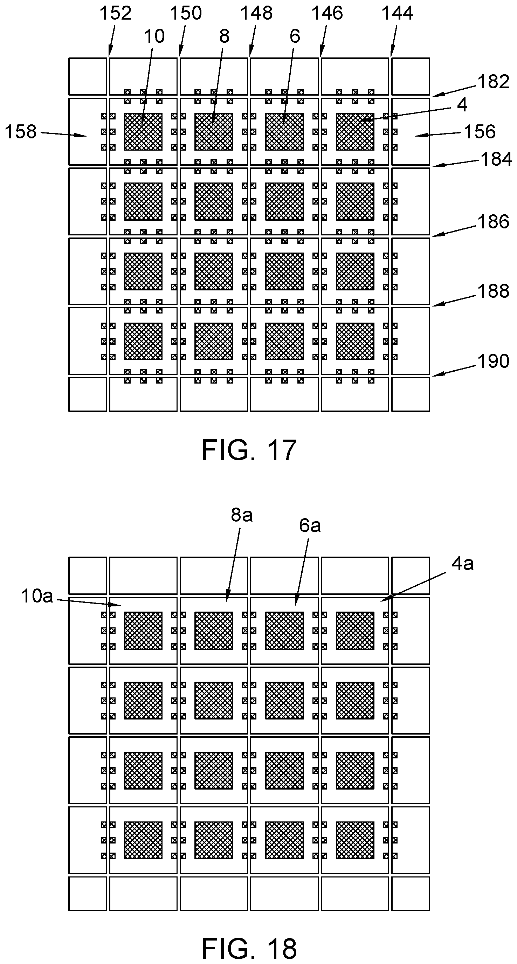

As will be appreciated by comparing Figure 1 with Figure 15, for example, at a later step of a method of manufacturing, each of the individual semiconductor packages are singulated (i.e. removed) from the array 2. This is also shown in Figures 17 and 18.

Returning to Figure 1, the array of semiconductor packages 2 comprises a plurality of die paddles 12, 14, 16, 18. The die paddles 12, 14, 16, 18 are conductive plates of material to which other components of the semiconductor packages 4, 6, 8, 10 are attached (at least in the illustrated embodiment). The die paddles 12, 14, 16, 18 may otherwise be referred to as thermal pads. As shown in Figure 1, the die paddles 12, 14, 16, 18 may form part of a wider lead frame 20, the lead frame 20 being a plate of material from which material is selectively removed (e.g. stamped or etched) to define a layout. The lead frame 20 may be manufactured from any suitable process, such as building the layers (e.g. plating) on a substrate or a non-core method.

Coupled to the plurality of die paddles 12, 14, 16, 18 are a plurality of dies 22, 24, 26, 28. One die is coupled to each die paddle. The dies 22, 24, 26, 28 may be referred to as silicon chips. The dies 22, 24, 26, 28 are preferably coupled to the respective die paddle 12, 14, 16, 18 by a die attach. The die attach may comprise solder or epoxy. A solder and/or epoxy layer may be disposed between the die and die paddle.

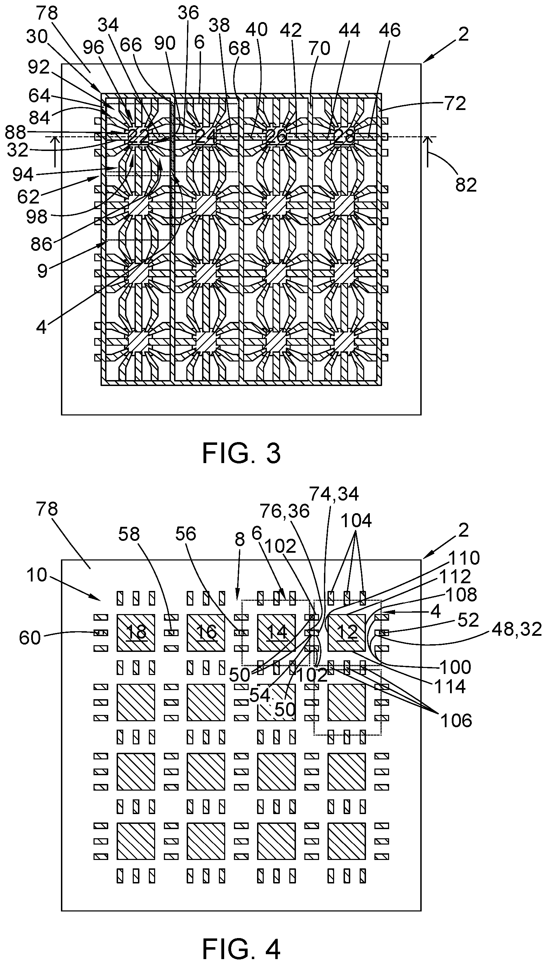

The array 2 further comprises an interconnected lead array 30. The interconnected lead array 30 comprises a plurality of leads (e.g. first to eighth leads 32, 34, 36, 38, 40, 42, 44, 46 as visible in Figure 1). The plurality of leads are also labelled in connection with Figure 3, which shows the array in a cross-section plan view. The interconnected lead array 30 may be described as a redistribution layer, or comprising a redistribution layer. The interconnected lead array 30 is preferably manufactured using a plating process.

The array 2 (as shown in Figures 1 and 2) can be manufactured in a number of different ways. As mentioned above, in one method the lead frame 20, defining the plurality of die paddles 12, 14, 16, 18, is first provided. Dies 22, 24, 26, 28 may then be coupled to the die paddles 12, 14, 16, 18. The interconnected lead array 30 may then be formed, by a process such as plating. A fused encapsulant 78 may then be moulded over the subassembly. In a variant of this process, the die paddles 12, 14, 16, 18 may be formed by a plating process on a substrate (e.g. the substrate being a material like that of a PCB).

In a variation of the above method, a first portion of the fused encapsulant 78 may be moulded. The interconnected lead array 30 may then be formed, by a process such as plating, into/within the first portion of the fused encapsulant 78. Dies 22, 24, 26, 28 may then be coupled to respective portions of the lead array 30 (e.g. dies coupled to the interconnected lead array). Die paddles 12, 14, 16, 18 may then be coupled onto, or plated onto, the dies 22, 24, 26, 28. A second portion of the fused encapsulant 78 may then be moulded (i.e. a multi-step moulding process).

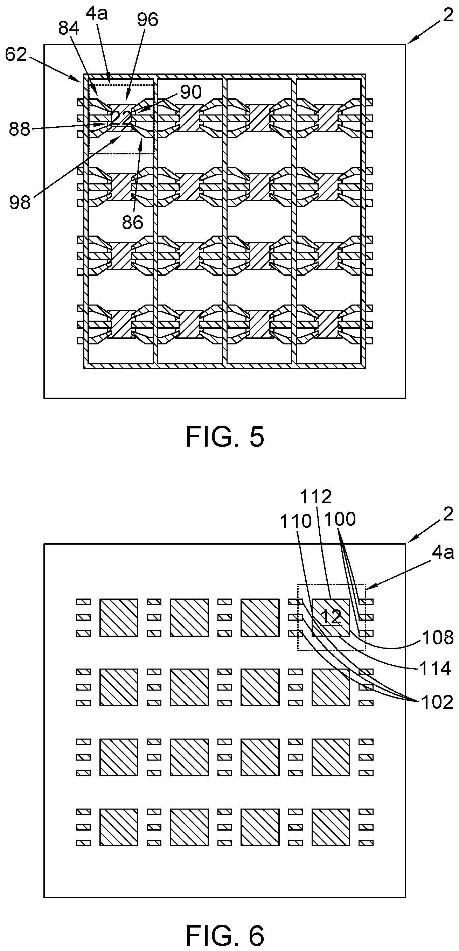

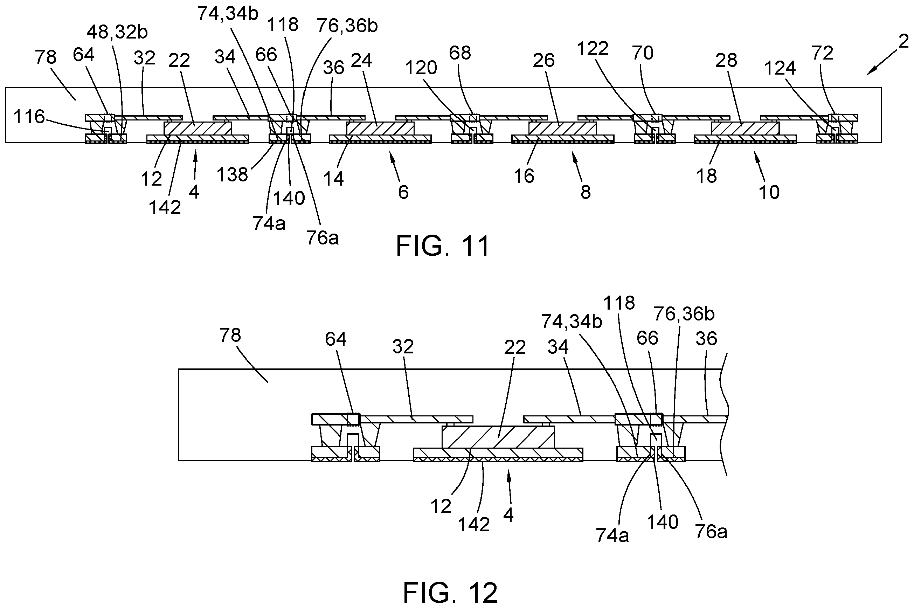

The interconnected lead array 30 is so-called because each of the plurality of leads are connected to one another. Again, this is shown in connection with Figures 3 and 5. This is advantageous when it comes to an electroplating process, which will be described later in connection with Figure 11, because all of the semiconductor packages 4, 6, 8, 10 can be held at the same potential, while still forming part of the array 2 and not requiring each individual semiconductor package 4, 6, 8, 10 be individually connected. The electroplating process can thus be more readily carried out.

Each of the plurality of leads is (directly) connected to one of the dies 22, 24, 26, 28. As shown in connection with each of Figures 3 and 5, in practice each conductor package comprises a plurality of leads connected to each die. As shown in Figure 3, first to fourth pluralities of leads 84, 86, 92, 94 extend from first to fourth sides 88, 90, 96, 98 of the die 22 respectively. This is referred to as a semiconductor package having a four-sided configuration (e.g. having leads which extend from each of four sides). In connection with Figure 5, only first and second pluralities of leads 84, 90 extend from first and second sides 88, 90 of the die 22. No leads extend from the third and fourth sides 96, 98 of the die 22. This is referred to as a semiconductor package having a two-sided configuration. Either a two, or four, sided configuration can be utilised in practice, and the primary difference between the two embodiments is the layout of the pads by which the semiconductor package is connected to the PCB. For the avoidance of doubt, the invention can be used in combination with either a two-sided, or a four-sided configuration.

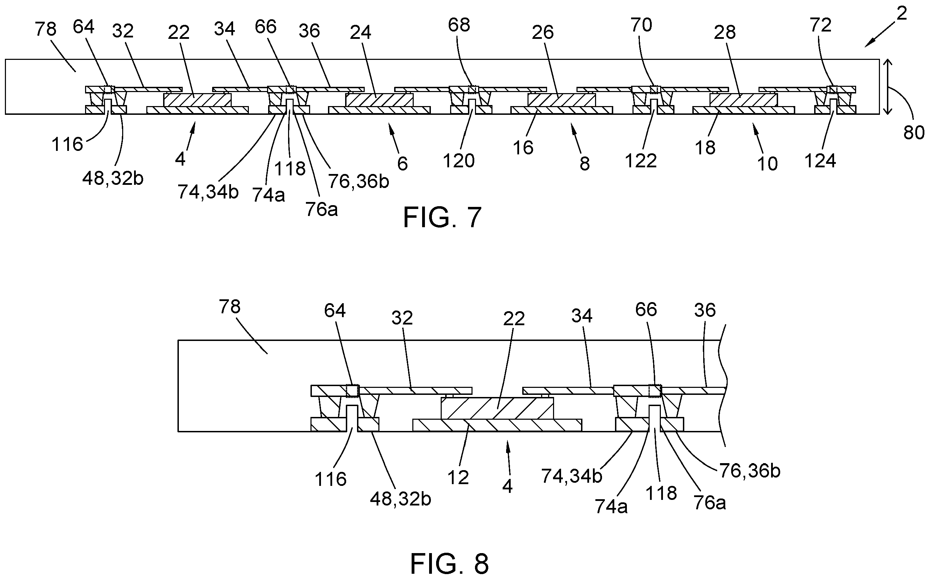

Returning to Figure 1, and taking the first lead 32 as an example, each lead is connected to a respective die (first die 22 for first lead 32) at a first end 32a. Further, each of the plurality of leads defines a pad (48 for the first lead 32) for attachment to the PCB. The pad (48 for the first lead 32) is defined at a second end of the lead (32b for the first lead 32). As such, when the semiconductor package has been singulated and is connected to a PCB, electrical signals can pass to the respective die through the lead via the pad. Of note, as will be appreciated from Figures 7 and 8, in a subsequent step of the process a removal of at least part of the interconnected lead array 30 will result in the definition of individual pads from the coupled pairs of leads shown in Figure 1 (e.g. between second and third leads 34, 36). With reference to the two-part fused encapsulant 78 described above, the first portion of the fused encapsulant 78 may comprise the portion of the fused encapsulant 78 extending to the leads 32, 34, 36 etc. The second portion of the fused encapsulant 78 may comprise the portion of the fused encapsulant 78 extending from the leads 32, 34, 36 etc. to the die paddles 12, 14, 16, 18.

The interconnected lead array 30 further comprises first and second sets of interconnecting tracks. A first set of interconnecting tracks 50, as shown in part in Figure 1, comprises first, second, third, fourth and fifth constituent tracks 52, 54, 56, 58, 60. As will be appreciated from Figure 1, the constituent tracks 52, 54, 56, 58, 60 of the first set of tracks 50 are not stand-alone and separate tracks per se, but are integral with coupled pairs of adjacent pluralities of leads. For example, taking the second track 54 as an example, the second and third leads 34, 36, associated with the first and second dies 22, 24 respectively, form a coupled pair by virtue of the second and third leads 34, 36 being directly connected to, and integral with, one another as shown in Figure 1. Upon removal of the first and second sets of interconnecting tracks (e.g. tracks 54, 66)), the second and third leads 34, 36 are separated from one another and are thus electrically isolated from one another. However, for various stages during the manufacturing process (preferably all of them up, until a singulation step), it is desirable that the dies remain electrically connected to one another, by virtue of the interconnected lead array 30. Electroplating of various surfaces of the array 2 can be more readily carried out when the leads of the array 2 are electrically connected to one another (by virtue of the interconnected lead array 30). This will be described in detail below.

Returning briefly to Figure 1, as will be described in connection with the manufacturing step shown in Figure 7, whereby the first set of interconnecting tracks 50 is at least partially removed, by virtue of the removal of the first set of interconnecting tracks 50, the pads of the coupled pair of leads are exposed (e.g. see pads 74, 76 of leads 32, 34). This is advantageous for reasons of being able to electroplate the flanks 74a, 76a (e.g. sides) of the pads 74, 76. Side-wettable flanks of the singulated semiconductor packages are thus defined at a later step of the process.

Although not described in detail, the above description also applies equally to each of the first, third, fourth and fifth tracks 52, 56, 58, 60 (albeit with references modified to reflect the different positions of each of these tracks).

Returning to Figure 1, as previously mentioned the interconnected lead array 30 further comprises a second set of interconnecting tracks 62. As shown in Figure 1 the second set of interconnecting tracks comprises sixth to tenth tracks 64, 66, 68, 70, 72. The sixth to tenth tracks 64, 66, 68, 70, 72 may otherwise be referred to as first to fifth constituent tracks of the second set interconnecting tracks 62.

Whilst the first set 50 of interconnecting tracks generally extend between pads of the plurality of leads, the second set of interconnecting tracks 62 extend between coupled pairs of the plurality of leads at a position partway along an extent of the leads. Put another way, taking the second track 54 of the first set of interconnecting tracks 50 as an example, the second track 54 extends between the coupled pair of the second and third leads 34, 36. The second track 54 specifically extends between pads 74, 76 of each of the second and third leads 34, 36. The pads 74, 76 are disposed at second ends 34b, 36b of each of the second and third leads 34, 36 respectively. Turning to the seventh track 66, or the second constituent track of the second set of interconnecting tracks 62, this track also extends between the second and third leads 34, 36 but from a position partway along an extent of the leads 34, 36 (i.e. between a first end connected to the die, and the second end which defines the pad).

For completeness, the second set of interconnecting tracks 62 are also shown and labelled in connection with Figure 3, for an array comprising semiconductor packages having a four-sided configuration, and Figure 5, for an array comprising semiconductor packages having a two-sided configuration.

Returning to Figure 1, the array 2 further comprises an encapsulant 78. The encapsulant 78 may otherwise be described as an epoxy molding compound. The encapsulant 78 takes the form of a protective casing which at least partly surrounds each of the dies 22, 24, 26, 28 and the plurality of leads. As shown in Figure 1, and for ease of description, the encapsulant 78 is described as a fused encapsulant owing to the fact that, as previously described, Figure 1 shows a plurality of conjoined semiconductor packages 4, 6, 8, 10. In a later step of the process when the semiconductor packages are singulated, the fused capsulant 78 is also separated so as to define a plurality of separate encapsulants (i.e. one for each of the plurality of semiconductor packages - see encapsulants 166, 168, 170 and 172 in Figure 15). The fused encapsulant 78 defines a thickness labelled 80 in Figure 1. The thickness 80 is substantially normal to major surfaces of each of the dies. The thickness 80 may be described as a minor (i.e. the smallest) dimension of the (singulated) semiconductor packages.

Turning to Figure 2, Figure 2 is a magnified view of a region of interest of that shown in connection with Figure 1. Accordingly, Figure 2 will not be described in detail.

Turning to Figure 3, as previously mentioned Figure 3 is a cross-section plan view of the array 2 shown in Figure 1. Figure 3 is taken from the perspective of being partway through the thickness 80 of the encapsulant 78. Figure 1 can be considered to be a cross-section side view taken about a plane labelled 82 in Figure 3.

Figure 3 shows a 4 x 4 array of dies, and so semiconductor packages. From Figure 3 it will be appreciated that each of the dies (first to fourth being labelled 22, 24, 26, 28 respectively) can be electrically connected to one another by virtue of the interconnected lead array 30.

For each of the first and second semiconductor packages 4, 6, along with a fifth semiconductor package 9, an approximate footprint (e.g. boundary) is schematically indicated by a dashed line in Figure 3 (and 4). Although the semiconductor packages all form part of the array 2 in Figures 3 and 4, in a (subsequent) singulation step they will be separated from one another and will have the schematically indicated footprint.

Taking the first semiconductor package 4 as an example, as mentioned Figures 3 and 4 show an array of semiconductor packages having a four-sided configuration. As such, first and second pluralities of leads 84, 86 extend from first and second sides 88, 90 of the die 22 (or die paddle 12, in the case of Figure 4) respectively. First and second sides 88, 90 are opposing sides of the die 22. Because the semiconductor package 4 is a four-sided configuration, third and fourth pluralities of leads 92, 94 extend from third and fourth sides 96, 98 of the die 22 respectively. The third and fourth sides 96, 98 are opposing sides. Leads thus extend from each of four sides of the die.

Turning to Figure 4, an underside view of the array 2 is provided.

From Figures 1 and 2 it will be appreciated that the underside view of Figure 4 shows an array of die paddles (e.g. first to fourth die paddles 12, 14, 16, 18) and a plurality of pads, where various pairs of pads are interconnected, to form a coupled pair of leads, by portions of the first set of interconnected tracks 52. For example, taking the first and second die paddles 12, 14 as examples, corresponding to first and second semiconductor packages 4, 6 respectively, pads 74, 76 are defined by second and third leads 34, 36 respectively. These are referred to as a coupled pair of leads because the second constituent track 54 of the first set of interconnecting tracks extends between the second and third leads 34, 36 (i.e. between the pads 74, 76 thereof). In a subsequent step of the process the second constituent track 54 will be at least partially removed, preferably entirely removed, to define separated pads 74, 76 and to expose flanks thereof. However, in the intermediate step shown in Figure 4, which corresponds to that shown in Figure 1, the pluralities of leads form coupled pairs because the first set of tracks has not yet been at least partially removed to define separated pads. As such, adjacent die paddles which are directly coupled to one another by virtue of the pairs can be referred to as coupled pairs of die paddles and/or semiconductor packages.

As shown in Figure 4, a respective plurality of pads, taking the first die paddle 12 as an example, are provided on each side of the die paddle. For example, first, second, third and fourth pluralities of pads 100, 102, 104, 106 are provided on each of first to fourth sides 108, 110, 112, 114 of the die paddle 12 respectively. Also labelled in Figure 4 are some of the constituent tracks of the first set of interconnecting tracks 50. First to fifth constituent tracks are labelled 52, 54, 56, 58, 60. Further tracks, adjacent the second constituent track 54, are generally labelled 50 (as well as the second track 54) to indicate further examples of the first set of interconnecting tracks 50. comparing Figures 3 and 4, specifically tracks 54 and 66, it will be appreciated that, whilst the second set of interconnecting tracks 62 are continuously extending tracks (e.g. extending across a majority of the array 2, and along multiple semiconductor packages), the first set of interconnecting tracks 50 are a series of discrete tracks (e.g. each constituent track only extending along a width of the pads, and having a width less than an individual semiconductor package). Put another way, whilst a constituent track of the first set of interconnecting tracks 50 only extends between exactly two dies/semiconductor packages/leads, by virtue of being disposed between two adjacent pads of a couple pair, constituent tracks of the second set of interconnecting tracks 62 may extend between more than two dies/semiconductor packages, preferably all forming part of the array, because of the elongate nature of the tracks and web-like layout.

Figures 5 and 6 correspond generally to Figures 3 and 4, other than they show an array of semiconductor packages which have a two-sided configuration. As such, leads only extend from two opposing sides of each die/die paddle/semiconductor package, as opposed to the four that the four-sided configuration extend from, as shown in Figures 3 and 4. For example, taking a first die 22, corresponding to a first semiconductor package 4a, first and second pluralities of leads 84, 86 extend from (opposing) first and second sides 88, 90 of the first die 22 respectively. The (opposing) third and fourth sides 96, 98 do not have any associated pluralities of leads which extend therefrom. Correspondingly, as shown in Figure 6, a die paddle 12, corresponding to the first semiconductor package 4a and first die 22, comprises first and second pluralities of pads 100, disposed adjacent first and second sides 108, 110 of the die paddle 12 respectively. Contrastingly, no pluralities of leads are disposed adjacent third and fourth sides 112, 114 of the die paddle 12. The array 2 shown in Figures 5 and 6 is thus an array of semiconductor packages which have a two-sided configuration.

Turning to Figure 7, a cross-section side view of the array 2 is shown at a further step of the manufacture process. As will be appreciated by comparing Figures 1 and 7, in Figure 7 the first set of the connecting tracks 50 has been at least partially removed (completely removed in this embodiment) to define pads. Specifically, and with reference to Figure 1, first to fifth constituent tracks 52, 54, 56, 58, 60 have been completely removed. With reference to the first and second semiconductor packages 4, 6 shown in Figure 7, removal of the first set of interconnecting tracks 50 forms first, second, third, fourth and fifth cavities 116, 118, 120, 122, 124. Taking the second cavity 118 as an example, the presence of the second cavity 118 defines separated pads 74, 76 corresponding to second and third tracks 34, 36 respectively. As well as defining the separated pads 74, 76, the cavity 118 also effectively exposes at least part of a flank, labelled 74a, 76a, of each of the pads 74, 76. The flank may otherwise be described as a side of the pads, or some form of a vertical surface (e.g. extending in a direction corresponding to the thickness of the array/semiconductor package). The cavities 116, 118, 120, 122, 124 extend only partway through the thickness 80 of the encapsulant (e.g. and may be described as blind cuts).

Exposing the flanks of the various pads (e.g. flanks 74a, 76a for pads 74, 76 respectively) at this step is advantageous for the reason that the flanks of the pads can be electroplated in a subsequent step of the process. This allows a singulated semiconductor package, when being connected to a PCB, to be soldered by the flank as well as by an underside of the pad. This advantageously means that the semiconductor package is more securely coupled to the PCB. Furthermore, by being able to solder part of a flank of the pad, a greater height of solder can be used than would otherwise be the case if the solder were only applied to the underside of the pad. For certain inspection operations (e.g. quality control processes), being able to apply solder to the flank of the pad means that the soldered joint can be more readily inspected. This is particularly important for certain sectors, such as automotive, where a minimum thickness of, for example, 100 microns of solder may be needed for a soldered joint to pass quality control. A flank which is suitable for having solder applied to it may be referred to as a side-wettable flank (SWF).

Whilst being able to electroplate the exposed flanks is advantageous for the reasons set out above, the invention advantageously also provides an electrical connection between the dies/semiconductor packages even after the first set of interconnecting tracks has been removed. That is to say, because the second set of interconnecting tracks (e.g. first to fifth constituent tracks 64, 66, 68, 70, 72) are still in position, the dies 22, 24, 26, 28 are still connected to one another by virtue of the interconnected lead array 30. The electroplating can thus be more readily applied to all of the relevant surfaces simultaneously, without needing to separately connect each of the dies to one another or to a common electrical source (e.g. so that all of the surfaces to be electroplated can be held at the same potential). The second set of interconnecting tracks 62, which advantageously extend between coupled pairs of leads partway along an extent of the leads (e.g. second constituent track 66 extending from partway along an extent of the leads 34, 36) is thus not removed when the flanks of the pads are exposed (by removal of the first set of interconnecting tracks 50).

For completeness, it will be appreciated that when the cavities 116, 118, 120, 122, 124 are formed (e.g. described another way, when the first set of interconnecting tracks 50 is at least partly removed), part of the fused encapsulant 78 is also removed. As such, a combination of the second set of interconnecting tracks 62 (e.g. which may be copper) and the fused encapsulant 78 is removed. It will be appreciated that the at least partial removal of the first set of interconnecting tracks 50 may occur simultaneously or sequentially. For example, the cavities 116, 118, 120, 122, 124 may be formed simultaneously or may be formed consecutively (e.g. the second cavity 118 may be formed after the first cavity 116 and so on) as part of the removal step of the process. The removal may occur by one or more of sawing, laser cutting, water jetting or etching.

Figure 8 is a magnified view of a region of interest of Figure 7. The first cavity 116 will now be described in more detail.

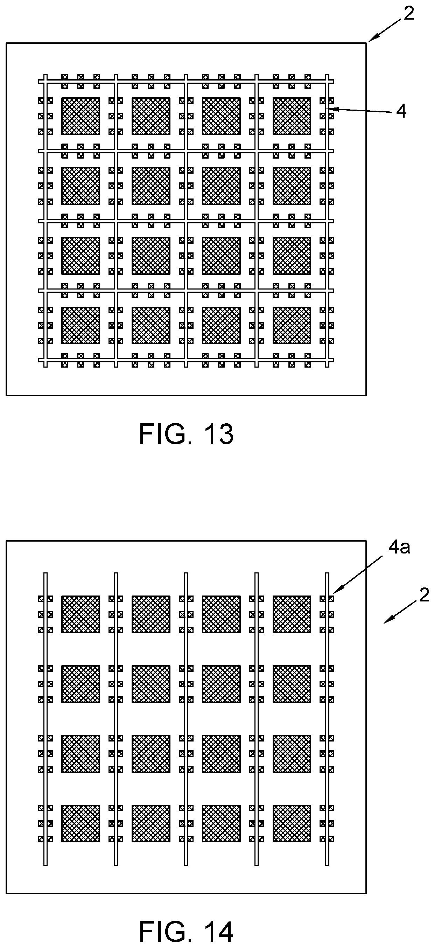

For pads of semiconductor packages which are disposed around an outside of the array (e.g. the first semiconductor package 4) interconnecting tracks (e.g. track 64) interconnect the (outer) lead 32, coupled to the die 22, to a redundant lead 126 which is eventually discarded as part of the singulation step. That is to say, redundant lead 126 does form part of any semiconductor package and will be discarded. See, for example, Figures 13 and 14.

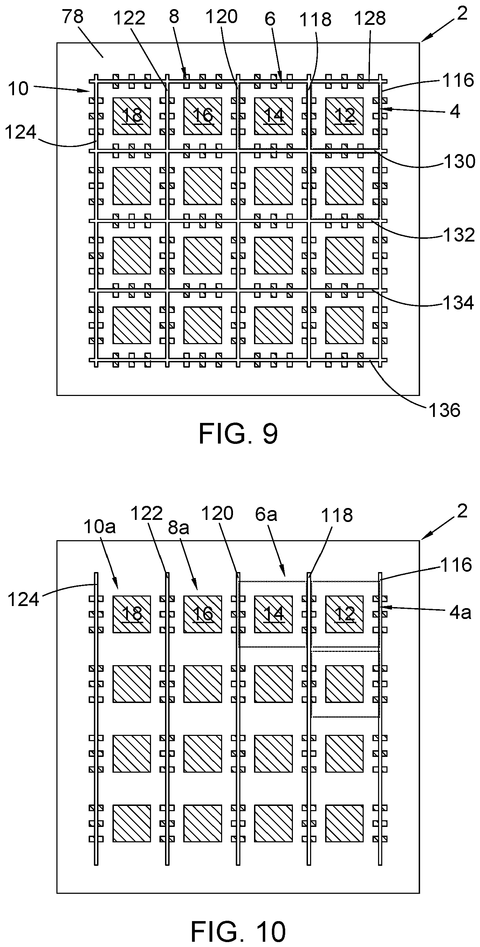

Turning to Figure 9, an underside view of the array 2 for the step shown in Figure 7 is provided. The array 2 is the same as that shown in Figure 3, and thus corresponds to an array comprising semiconductor packages having four-sided configurations. Similarly, Figure 9 thus shares many features in common with that shown in Figure 4, and only the differences will be described in detail.

As mentioned, Figure 9 shows an underside view of the array 2 after the first set of interconnecting tracks 50 has been removed. As such, shown in Figure 9 are the various cavities left after the first set of interconnecting tracks 50 has been removed. With reference to Figure 7, each of the first, second, third, fourth and fifth cavities 116, 118, 120, 122, 124 are labelled in Figure 9. As will be appreciated from Figure 9, each of the first to fifth cavities, 116, 118, 120, 122, 124 is interconnected, as part of a cavity array, by sixth, seventh, eighth, ninth and tenth cavities 128, 130, 132, 134, 136. As such, all of the cavities form an interconnected array for the four-sided configurations of semiconductor packages. Also from Figure 9 it will be appreciated that each of the cavities could otherwise be described as trenches owing to their elongate nature. Furthermore, in the illustrated embodiment each of the first to fifth cavities 116, 118, 120, 122, 124 extend in a vertical (e.g. first) direction, whilst each of the sixth to tenth cavities 128, 130, 132, 134, 136 extends in a horizontal (e.g. second) direction. The first direction is perpendicular to the second direction. The cavities may be described as forming a web.

Taking the first semiconductor package 4 as an example, corresponding to die paddle 12, the first semiconductor package 4 is bound by first and second cavities 116, 118 on first and second sides and is bound by sixth and seventh cavities 128, 130 on third and fourth sides respectively. For completeness, indicated by dashed lines are the approximate boundaries for each of three semiconductor packages. Said dashed lines effectively correspond to the cavities formed by removal of the first set of interconnecting tracks 50.

Turning to Figure 10, an underside view of the array 2, at the step shown in Figure 7, corresponding to the two-sided configuration shown in Figures 5 and 6 is provided. For completeness, Figure 10 is shown with this embodiment at the same stage of the manufacture process as that four side embodiment shown in Figure 9 i.e. as shown in Figure 7, with a first set of interconnecting tracks at least partly removed. By comparing Figures 9 and 10 it will be appreciated that for an array comprising semiconductor packages having a two-sided configuration the horizontally extending cavities (e.g. sixth to tenth cavities 128, 130, 132, 134, 136 of Figure 9) are omitted. This is owing to the fact there are no leads extending from respective dies third and fourth sides for a semiconductor package having a two-sided configuration. A further distinction is that each of the first to fifth cavities 116, 118, 120, 122, 124 are not interconnected like that shown in Figure 9. Instead, they are each separate (e.g. discrete) cavities. Furthermore, all extend in the same (vertical) direction, and are parallel to one another.

Turning to Figure 11, a plating step of the method of manufacture of the array 2 is shown. As will be appreciated by comparing Figures 7 and 11, the only difference between these process steps is that exposed metal material disposed at an underside of the array 2 is coated.

Taking the pads 74, 76 between the first and second dies 22, 24 respectively, it will be appreciated that each of an underside and the flank 74a, 76a is plated. Put another way, a layer of (metal) plating material has been applied to the surfaces. The plating preferably occurs by an electrolytic plating process. The plating is preferably a metal such as tin or silver, but other materials can otherwise be used.

The exposed flanks 74a, 76a of each of the pads can be plated due to the cavities (e.g. second cavity 118) which were formed in the step shown in Figure 7. Furthermore, advantageously, because the second set of interconnecting tracks 62 still remains (e.g. first to fifth constituent tracks 64, 66, 68, 70, 72) each of the dies, and associated leads, of each semiconductor package in the array 2 remains electrically coupled to one another despite the first set of interconnecting tracks having been removed. This advantageously means that the plating process is far simpler because each individual surface to be plated (e.g. each pad) does not need to be separately connected to an electrical circuit as part of the plating process. Instead, the entire array, other than the fused encapsulant 78, can effectively be held at the same potential by connecting it at only one or two points. As previously described, by advantageously plating the exposed flanks 74a, 76a of the pads, solder can subsequently be applied to the plated flanks of the pads of the semiconductor packages at the point of being coupled to a PCB.

As well as an underside and flank of the pads being plated, an underside of the die paddle for each of the semiconductor packages is also plated. For completeness, and only with reference to the pad 74 of the first semiconductor package 4, a pad underside plated surface is labelled 138, a pad flank plated surface is labelled 140, and the plated surface on the die paddle 12 is labelled 142.

Figure 12 is a magnified view of a region of interest at Figure 11 and will not be described in detail.

Turning to Figure 13, Figure 13 is a view of an underside of the array 2 as shown at the step of Figure 11. As described in connection with Figures 3, 4 and 9, Figure 13 corresponds to an array of semiconductor packages having a four-sided configuration. Figure 13 will not be described in particular detail beyond mentioning that Figure 13 corresponds to Figure 9 and differs only insofar as the exposed metal of the die paddles and pads of Figure 9 have had a plating layer applied to them as shown in Figure 13. Cavities formed by virtue of the first set of interconnecting tracks being removed are still visible in Figure 13 because these cavities are not metal surfaces and the plating material thus does not adhere to them. Similarly, the fused encapsulant 78 remains and is not plated because it is not a conductive material.

Figure 14 is a view of an underside of the array 2 shown in the step of Figure 11 but as applied to an array 2 comprising semiconductor packages having a two-sided configuration (e.g. as shown in Figures 5, 6 and 10). As such, Figure 14 corresponds largely to Figure 10, but, like that described above in connection with Figure 13, differs only insofar as the exposed metal surfaces have had a plating applied to them.

Turning to Figure 15, a cross-section side view of the array shown in Figure 11, after a singulation step has occurred, is shown.

By comparing Figure 15 with Figure 11, it will be appreciated that, in Figure 15, what was previously a fused encapsulant has been cut at a plurality of positions to singulate the semiconductor packages (i.e. first to fourth semiconductor packages 4, 6, 8, 10) from the array. As labelled in Figure 15, what was the fused encapsulant is cut at first, second, third, fourth and fifth positions 144, 146, 148, 150, 152. For the cross-section view shown in Figure 15, each of the semiconductor packages 4, 6, 8, 10 is bound by at least two cut positions (and a further two cut positions, which are not visible in Figure 15 but which will be shown in connection with Figures 17 and 18). As well as the previous array having the semiconductor packages singulated therefrom, at either end, as shown in Figure 15, two waste sections 154, 156 are separated. Owing to the waste sections 154, 156 not comprising a die, nor a corresponding semiconductor package, as suggested by the name these sections are discarded. These waste sections 154, 156 include redundant leads (e.g. 126 labelled in Figure 8).

Taking the second cut position 146 as an example, by comparing Figure 11 with Figure 15, when cutting occurs at the second cut position 146, what was previously the second cavity 118 then forms part of a stepped recess 158. The stepped recess is so called because a portion of the recess 160 which extends from the cavity 118 has a different width dimension. Described another way, the stepped recess 158 is not merely an extension of the cavity 118 insofar as it shares the same dimensions, because when cutting occurs at the second position 146 that portion 160 has a reduced width in comparison to the cavity 118. This explanation also follows for each of the other cut positions 144, 148, 150, 152 (e.g. a stepped recess is defined at each).

Also of relevance in connection with the cutting positons, cutting the fused encapsulant at these plurality of positons also comprises at least partially (and preferably entirely) removing the second set of interconnecting tracks 62 (i.e. constituent tracks 64, 66, 68, 70, 72 shown in Figure 11). At the point of removing the second set of interconnecting tracks 62, and with reference to the first and second semiconductor packages 4, 6 only, by cutting the fused encapsulant at the second position 146, thus removing the second constituent track 66 of the second set of interconnecting tracks 62 (see Figure 11), exposed portions 162, 164 of the second and third leads 34, 36 are defined. Furthermore, the exposed portions 162, 164 are defined at positions 34c, 36c partway along an extent of the leads 34, 36. Partway along an extent of the leads is intended to mean at a position along the leads between a first end (e.g. where the lead extends from the die) and the second end (where the pad is defined). As illustrated in Figure 15, the exposed portions 162, 164 are also located partway through the thickness 80 of the encapsulant. For completeness, an encapsulant associated with the first semiconductor package 4 is labelled 166 and encapsulants associated with each of the second, third, fourth semiconductor packages are labelled 168, 170, 172 respectively.

For the first track 32, cutting at the first positon 144 also defines an exposed portion 174 disposed at a position 32c partway along an extent of the first track 32.

The process carried out in accordance with the invention advantageously provides a plated, side-wettable flank (of the pads) while still being able to electrically couple all of the exposed surfaces of the array together without needing to individually connect the exposed surfaces to an electrical circuit to carry out electroplating. This would otherwise be the case were it not for the second set of interconnecting tracks 62 which, up until the cutting/singulation step shown in Figure 15, maintain an electrical connection throughout the semiconductor packages of the array. Side-wettable flanks of the pads advantageously improves the solderability performance of the semiconductor package.

Turning to Figure 16, Figure 16 is a magnified view of a region of interest of Figure 15 and will not be described in detail.

Turning to Figure 17, a view of an underside of the separated array as shown in the step of Figure 15 is provided.

Figure 17 shares many features in common with Figure 13, and the only notable difference is that the 'full' cutting steps have occurred at each of the first to fifth cutting positions 144, 146, 148, 150, 152, said cutting positions extending in a vertical (first) direction. Cutting of the fused capsulant also occurs at sixth to tenth cutting positions 182, 184, 186, 188, 190, said cutting positions extending in a horizontal (second) direction. The combination of all ten cutting positions thus defines a grid-like array, and separates each of the (sixteen, in the illustrated embodiment) semiconductor packages from the overall array. Furthermore, and as described in connection with Figure 15, first and second waste sections 156, 158 (among others), which will be discarded, are also separated.

As has previously been described, the cutting at the plurality of positions may occur simultaneously (i.e. at all of the positions at the same time) or may occur sequentially (for example, the cutting at the second position 146 may follow the cutting at the first positon 144 etc.). Cutting may occur by one or more various methods including sawing, laser cutting, and water jetting.

The step shown in Figure 17 completes the manufacture process for the batch of semiconductor packages, with the individual semiconductor packages having been singulated from one another.

Turning briefly to Figure 18, Figure 18 generally corresponds to that shown in Figure 17 but, as has been the case throughout the document, Figure 18 corresponds to semiconductor packages which have a two-sided configuration (e.g. as shown in Figures 5, 6, 10 and 14).

Throughout this document, method steps may have been explained/described with reference to only a single semiconductor package/component for brevity. However, it will be appreciated that said steps are carried out in connection with each die/die paddle/semiconductor package, whether simultaneously or sequentially, across the array, as part of the batch manufacturing.

The interconnected lead array, or constituent plurality of leads, may be described as being of panel form. For example, fan-out panel level packaging (FOPLP), fan-out wafer level packaging (FOWLP), quad-flat no-leads (QFN) etc.

## Claims

1. A semiconductor package for a printed circuit board, PCB, comprising:
a die paddle;
a die coupled to the die paddle;
a plurality of leads electrically connected to the die, each of the plurality of leads extending from the die at a first end, and defining a pad for attachment to the PCB at a second end; and
an encapsulant which at least partly surrounds the die and the plurality of leads, the encapsulant defining a thickness; wherein
one or more of the plurality of leads comprises an exposed portion, the exposed portion disposed partway along an extent of the lead between the first and second ends, the exposed portion being located partway along the thickness of the encapsulant.

2. The semiconductor package according to claim 1, wherein each of the plurality of leads comprises an exposed portion disposed partway along an extent of the lead between the first and second ends.

3. The semiconductor package according to claims 1 or 2, wherein, for one or more of the plurality of leads, the first end and the exposed portion are defined by a layer.

4. The semiconductor package according to any preceding claim, wherein the encapsulant comprises a stepped recess between the exposed portion and the pad of one or more of the plurality of leads.

5. The semiconductor package according to any preceding claim, wherein one or more of the pads comprises a metal plating, the metal plating extending at least partway along a flank of the one or more pads.

6. The semiconductor package according to any preceding claim, wherein a first plurality of leads extend from a first side of the die, and a second plurality of leads extend from a second, opposing side of the die.

7. The semiconductor package according to claim 6, wherein a third plurality of leads extend from a third side of the die, and a fourth plurality of leads extend from a fourth side of the die, the fourth side of the die opposing the third side of the die.

8. A method of manufacturing a batch of semiconductor packages, comprising:
coupling a plurality of dies and a plurality of die paddles to define an array, wherein each die paddle defines a respective semiconductor package, and coupling an interconnected lead array and the plurality of dies, the interconnected lead array comprising a plurality of leads, connected to the plurality of dies, and a plurality of sets of interconnecting tracks which extend between coupled pairs of the plurality of leads: a first set of interconnecting tracks extending between pads of at least some of the coupled pairs, and a second set of interconnecting tracks extending between at least some of the coupled pairs from a position partway along an extent of the leads of the at least some of the coupled pairs;
providing at least part of a fused encapsulant over the plurality of semiconductor packages, the at least part of the fused encapsulant at least partly surrounding the array;
removing the first set of interconnecting tracks to define the pads, and expose a flank of the pads, of the plurality of leads;
plating at least part of an underside of the pads, and at least part of the flank of the pads, using an electrolytic plating process; and
cutting the fused encapsulant at a plurality of positions to singulate the semiconductor packages from the array, wherein cutting the fused encapsulant comprises removing the second set of interconnecting tracks to define exposed portions of the plurality of leads.

9. The method according to claim 8, wherein cutting the fused encapsulant comprises defining a stepped recess between the exposed portion and the pad of one or more of the plurality of leads of the semiconductor package.

10. The method according to claims 8 or 9, wherein the encapsulant is moulded or provided by film lamination.

11. The method according to any one of claims 8 to 10, wherein the interconnected lead array is provided by plating or sputtering.

12. The method according to any one of claims 8 to 11, wherein removing the first set of interconnecting tracks to define pads, and expose a flank of the pads, of the plurality of leads, occurs by a cutting operation.

13. The method according to any one of claims 8 to 12, wherein plating at least part of an underside of the pads, and at least part of the flank of the pads, using an electrolytic plating process comprises providing each of the plurality of leads at substantially the same potential by connecting the interconnected lead array to a supply circuit.

14. The method according to any one of claims 8 to 12, wherein plating at least part of an underside of the pads, and at least part of the flank of the pads, using an electrolytic plating process comprises providing the at least part of the flank of the pads with at least 7 microns of plated material.

15. An array of semiconductor packages, comprising:
a lead frame comprising an array of die paddles, wherein each die paddle defines a respective semiconductor package;
a plurality of dies coupled to a respective plurality of die paddles;
an interconnected lead array extending between, and electrically coupling, the plurality of dies, the interconnected lead array comprising first and second sets of interconnecting tracks: a first set of interconnecting tracks extending between at least some of the pads of the coupled pairs of the plurality of dies, and a second set of interconnecting tracks extending between at least some of the coupled pairs from a position partway along an extent of the leads of the at least some of the coupled pairs; and
a fused encapsulant provided over the plurality of semiconductor packages, the fused encapsulant at least partly surrounding the array.
